# EUROPEAN PATENT APPLICATION

(11) **EP 4 783 101 A1**
(43) Date of publication of application: **29.07.2026**
(21) Application number: 24874948.3
(22) Date of filing: 02.10.2024
(51) Int. Cl.: G06Q 50/06, G06Q 50/10, G06F 30/20, H04W 4/38, H04W 4/33, G01D 21/02, F24F 11/50, F24F 11/30, H04L 12/28

(54) **METHOD FOR VISUALIZING ENVIRONMENT OF INDOOR SPACE, AND ELECTRONIC DEVICE FOR PERFORMING SAME**

(30) Priority: 04.10.2023 KR 20230131918; 08.01.2024 KR 20240003126
(71) Applicant: Samsung Electronics Co., Ltd., Suwon-si, Gyeonggi-do 16677 (KR)
(72) Inventor: KIM, Joonsoo, Suwon-si, Gyeonggi-do 16677 (KR); KIM, Jungwook, Suwon-si, Gyeonggi-do 16677 (KR); KIM, Taehoon, Suwon-si, Gyeonggi-do 16677 (KR); NAM, Jinwoo, Suwon-si, Gyeonggi-do 16677 (KR); BAIK, Kunhoon, Suwon-si, Gyeonggi-do 16677 (KR)
(74) Representative: Gulde & Partner
(86) International application number: PCT/KR2024/014973
(87) International publication number: WO 2025/075392

(57) **Abstract**

Provided is a method comprising the steps of acquiring a map representing an indoor space, receiving target information related to a target environment of the indoor space and current information related to the current environment of the indoor space, and visualizing, on a map, an environmental change of the indoor space on the basis of the target information and the current information.

## Description

### Technical Field

The present disclosure relates to a method of visualizing an environment of an indoor space, and an electronic device for performing the method.

### Background Art

The Internet is evolving from a human-centered network in which humans generate and consume information to an Internet of Things (IoT) network that exchanges and processes information between distributed components such as objects. Internet of Everything (IoE) technology, which combines loT technology with big data processing technology through connection with cloud servers, etc., is also emerging. The loT may be applied to fields such as smart home appliances, smart homes, smart buildings, and smart cities through convergence and integration between existing information technology (IT) technology and various industries.

In particular, efforts are being made to improve users' living environment, by visualizing a physical space and controlling an environment of an indoor space through appropriate devices. However, most common home appliances are fixed to their installation locations, and may be placed in corners of the home depending on the home appliances. Therefore, when users measure an overall environment of the indoor space through common home appliances, information is often biased to specific areas or is insufficient.

### Disclosure of Invention

### Solution to Problem

According to an embodiment of the present disclosure, a method may include obtaining a map representing an indoor space. The method may include receiving target information about a target environment of the indoor space and current information about a current environment of the indoor space. The method may include visualizing an environmental change of the indoor space on the map based on the target information and the current information.

According to an embodiment of the present disclosure, an electronic device may include memory and at least one processor. The memory may store one or more instructions. The at least one processor may execute a program or one or more instructions stored in the memory to cause the electronic device to obtain a map representing an indoor space. The electronic device may receive target information about a target environment of the indoor space and current information about a current environment of the indoor space. The electronic device may visualize an environmental change of the indoor space on the map based on the target information and the current information.

According to an embodiment of the present disclosure, a computer program may be stored in a medium to cause a computer to perform at least one of the embodiments of the disclosed method.

### Brief Description of Drawings

FIG. 1 is a diagram for explaining an operation of visualizing an environment of an indoor space, according to an embodiment of the present disclosure.
FIG. 2 is a flowchart for explaining a method of visualizing an environment of an indoor space, according to an embodiment of the present disclosure.
FIG. 3 is a diagram illustrating an example of an image visualizing an environment on an indoor space, according to an embodiment of the present disclosure.
FIG. 4 is a diagram for explaining elements utilized in a simulation for visualizing an environment of an indoor space, according to an embodiment of the present disclosure.
FIG. 5 is a flowchart illustrating a method of providing a solution as a result of a simulation visualizing an environment of an indoor space, according to an embodiment of the present disclosure.
FIG. 6 is a flowchart for specifically explaining a method of visualizing an environment of an indoor space, according to an embodiment of the present disclosure.
FIGS. 7A and 7B are diagrams for explaining user interfaces for providing, to a user, images in which an environment of an indoor space is visualized, according to an embodiment of the present disclosure.
FIG. 8 is a diagram for explaining a configuration of an electronic device for visualizing an environment of an indoor space, according to an embodiment of the present disclosure.

### Mode for the Invention

In describing the present disclosure, descriptions of technical content well known in the technical field to which the present disclosure belongs and not directly related to the present disclosure are omitted. This is to convey the gist of the present disclosure more clearly without blurring by omitting unnecessary explanations. The terms to be described below are defined by taking functionalities in the present disclosure into account, and may vary depending on practices or intentions of users or operators. Accordingly, the terms should be defined based on descriptions throughout the specification

For the same reason, some components in the accompanying drawings are exaggerated, omitted or schematically illustrated. The size of the respective components may not fully reflect their actual size. In the drawings, the same or corresponding components are given the same reference numerals.

Advantages and features of the present disclosure and methods for achieving them will become apparent with reference to the embodiments described below in detail together with the accompanying drawings. However, the present disclosure is not limited to the embodiments disclosed below, but may be implemented in various different forms. The disclosed embodiments are provided to ensure that the present disclosure is complete and to fully inform one of ordinary skill in the art the category of the present disclosure. An embodiment of the present disclosure may be defined according to the claims. The same reference numerals represent the same components throughout the specification. In addition, when it is determined that a detailed description of the relevant function or configuration in describing an embodiment of the present disclosure may unnecessarily obscure the gist of the present disclosure, the detailed description is omitted. The terms to be described below are defined in consideration of the function in the present disclosure, which may vary depending on the intention or custom of users or operators. Therefore, the definition should be based on the content throughout the specification.

In an embodiment, each block of flowchart drawings and combinations of the flowchart drawings may be performed by computer program instructions. The computer program instructions may be loaded to a processor of a universal computer, a special-purpose computer, or other programmable data processing equipment, and may thus generate means for performing functions described in the block(s) of the flowcharts when executed by the processor of the computer or the other programmable data processing equipment. The computer program instructions may also be stored in computer-usable or computer-readable memories that may be directed to computers or other programmable data processing equipment to implement functions in a specific manner, and instructions stored in computer-usable or computer-readable memories may also produce a manufacturing item containing instruction means for performing the functions described in the block(s) of the flowcharts. The computer program instructions may also be loaded onto a computer or other programmable data processing equipment.

In addition, each block of the flowchart may represent a part of a module, segment, or code including one or more executable instructions to perform particular logical function(s). In an embodiment, it is also possible that the functions mentioned in the blocks occur out of the sequence. For example, two successive blocks may be performed substantially at the same time or in reverse order depending on the corresponding functions.

The term "unit" used in an embodiment of the present disclosure may refer to a software or hardware component, such as a field programmable gate array (FPGA) or an application specific integrated circuit (ASIC), and may perform a particular function. However, the "unit" is not limited to software or hardware. The "unit" may be configured to be stored in an addressable storage medium, or to execute one or more processors. In an embodiment, the "unit" may include components, such as software components, object-oriented software components, class components and task components, processes, functions, attributes, procedures, subroutines, segments of program codes, drivers, firmware, microcodes, circuits, data, databases, data structures, tables, arrays, and variables. Functions provided through a certain component or a certain "unit" may be combined to reduce the number or divided into additional components. In an embodiment, the "unit" may also include one or more processors.

The embodiments of the present disclosure relate to a method of visualizing environment of an indoor space. Prior to describing specific embodiments, meanings of terms frequently used in the specification are distinguished.

In the present disclosure, the current environment and the target environment should be distinguished. The current environment refers to a current environment within a predetermined space, and the target environment refers to an environment set as a target so that the environment of the predetermined space reaches the future. The current environment and the target environment may be defined with respect to various environmental factors that a predetermined space may have, for example, temperature, humidity, and air quality.

Hereinafter, a method of visualizing an environment of an indoor space, and an electronic device for performing the method will be described with reference to the drawings.

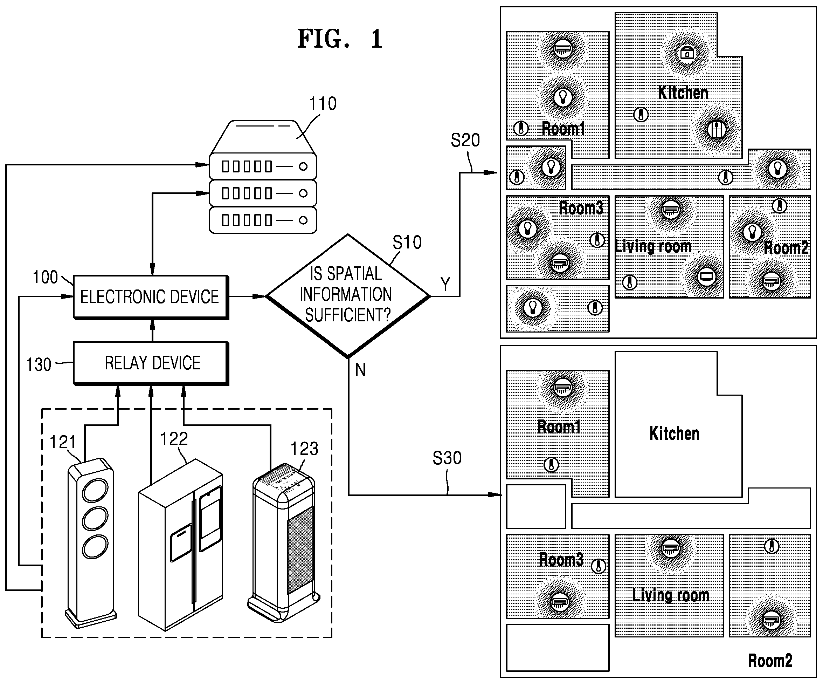

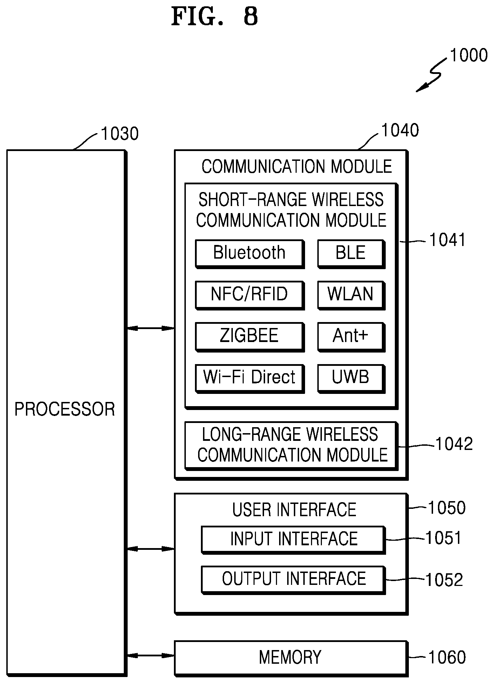

It is assumed that processes described in the present disclosure are performed by the electronic device. Accordingly, in describing FIGS. 1 to 8, the electronic device will be described as performing the processes. Detailed components included in the electronic device according to an embodiment are shown in FIG. 8, and will be described below in detail.

FIG. 1 is a diagram for explaining an operation of visualizing an environment of an indoor space according to an embodiment of the present disclosure.

Referring to FIG. 1, a system according to an embodiment may include an electronic device 100, a server 110, external devices 121, 122, 123, and a relay device 130.

The external devices 121, 122, and 123 according to an embodiment may be one or more devices placed in the indoor space to be visualized by the electronic device 100. The electronic device 100 may visualize the environment of the indoor space, by using information about the indoor space received from the external devices 121, 122, and 123.

In an embodiment, the external devices 121, 122, and 123 may be one or more devices. In FIG. 1, the external devices 121, 122, and 123 are illustrated as three devices, but the number of external devices is merely an example, and does not limit the technical idea of the present disclosure. In addition, the external devices 121, 122, and 123 are illustrated as an air conditioner, a refrigerator, and an air purifier, respectively, but types of external devices 121, 122, and 123 do not limit the technical idea of the present disclosure.

In an embodiment, the external devices 121, 122, and 123 may each include an actuator that changes an environment of a space in which the external devices 121, 122, and 123 are placed. The external devices 121, 122, and 123 may each include the actuator that influences the environment of the indoor space to reach a target environment.

The actuator may set the target environment and influence the environment of the indoor space to reach the set target environment. For example, the actuator may include an air conditioner that cools the indoor space so that a temperature of the indoor space reaches 21 degrees. As another example, the actuator may include a humidifier that controls a humidity of the indoor space to reach 50 %.

In addition, the actuator is a device that influences the environment of the indoor space, may include a device that influences an environment, such as temperature, humidity, power consumption, heat dissipation, noise, etc., and may include an air conditioner, a heater, an air purifier, a lighting device, a refrigerator, a TV, a computer, washing machine, etc. The type of actuator does not limit the technical idea of the present disclosure.

In an embodiment, the external devices 121, 122, and 123 may each include an observer that measures an environment of a space in which the external devices 121, 122, and 123 are placed. The external devices 121, 122, and 123 may measure the environment of the indoor space by using sensors provided in various ways.

For example, the observer may include an electronic thermometer that measures a temperature of the indoor space. As another example, the observer may include an electronic hygrometer that measures a humidity of the indoor space.

In addition, an observer is a device that measures the environment of the indoor space, may include a device that measures the environment of the indoor space, such as temperature, humidity, power consumption, heat dissipation, noise, etc., and may include a digital thermometer, a hygrometer, a carbon dioxide meter, an air purifier, a light meter, a noise meter, etc. Alternatively, an air conditioner, a heater, an air purifier, a lighting device, a refrigerator, a TV, a computer, washing machine, etc. may also be included in the observer that measures the environment of the indoor space through built-in sensors. The type of observer does not limit the technical idea of the present disclosure.

In an embodiment, the external devices 121, 122, and 123 may each operate as an actuator and an observer. For example, the external devices 121, 122, and 123 may each include an air conditioner that measures an indoor temperature while cooling a indoor temperature to change the indoor temperature. The air conditioner may simply serve as an actuator that influences the environment of the indoor space, but may also serve as an observer as well as the actuator according to technological advances.

In an embodiment, the electronic device 100 may obtain spatial information from various devices. The electronic device 100 may receive spatial information from an external device through a communication unit. As the electronic device 100 obtains a user input through a user interface, the electronic device 100 may directly generate spatial information.

For example, the electronic device 100 may directly receive spatial information from the external devices 121, 122, and 123. The external devices 121, 122, and 123 may be devices placed in the indoor space, and may obtain spatial information related to the indoor space and locations of the external devices 121, 122, and 123 disposed in the indoor space. The electronic device 100 may receive spatial information stored in the external devices 121, 122, and 123 through the communication unit.

A communication method between the electronic device 100 and the external devices 121, 122, and 123 does not limit the technical idea of the present disclosure, and for example, the electronic device 100 may receive spatial information from the external devices 121, 122, and 123 by using a near field communication (NFC) method or a Bluetooth method.

For example, the electronic device 100 may obtain spatial information from the relay device 130. The relay device 130 may be a hub device that connects several devices placed within the indoor space to help exchange data. The relay device 130 may be placed in the indoor space. The relay device 130 may receive spatial information from the external devices 121, 122, and 123 placed in the indoor space, and the electronic device 100 may receive the spatial information obtained by the external devices 121, 122, and 123 through the relay device 130.

The relay device 130 merely refers to a hub device for transmitting data of various devices among electronic devices placed in the indoor space, and the type of the relay device 130 does not limit the technical idea of the present disclosure. For example, the relay device 130 may include an electronic device that serves as a hub, such as an artificial intelligence (AI) speaker, a mobile phone, a computer, an air conditioner, etc.

For example, the electronic device 100 may obtain spatial information from the server 110. The server 110 may store spatial information about various indoor spaces. The electronic device 100 may obtain pre-stored spatial information from the server 110. The electronic device 100 may receive, from the server 110, spatial information corresponding to the indoor space selected according to a user input.

The server 110 may store, for example, spatial information about a structure of the indoor space and a placement of furniture. The server 110 may receive spatial information from the external devices 121, 122, and 123 through an access point (AP). The electronic device 100 may receive spatial information from the server 110.

In an embodiment, the electronic device 100 may obtain spatial information from a user terminal. For example, the user terminal may provide a predetermined application for virtually editing the indoor space, and the electronic device 100 may receive edited spatial information through the user terminal. The edited spatial information may include information about the indoor space edited according to a user input through the user terminal.

However, at least part of data processing performed in the above-described operations of obtaining spatial information may be performed by the server 110, or may be directly performed by a processor of the electronic device 100. This does not limit the technical idea of the present disclosure.

In an embodiment, the spatial information may include a map representing the indoor space. The spatial information may further include information about at least one of the at least one external devices 121, 122, and 123 or an obstacle which are placed in the indoor space. The spatial information may be information about things that influences the environment of the indoor space. That is, the spatial information may include information about a structure and size of the indoor space that is displayable through a map of the indoor space, or information about the external devices 121, 122, 123 and the obstacle which are objects disposed in the indoor space.

However, all of the components shown in FIG. 1 are not essential components. The system according to an embodiment of the present disclosure may be implemented by more components than the illustrated components, or may be implemented by fewer components. For example, the system of an embodiment may be implemented as the electronic device 100, a first external device, and a second external device, or may be implemented as the first external device, the second external device, and a mobile terminal (not shown).

In an embodiment, in operation S10, the electronic device 100 may determine whether the obtained spatial information is sufficient.

In an embodiment, the electronic device 100 may set sufficient conditions as to whether the obtained spatial information is sufficient. The sufficient conditions may be set differently according to an intention for simulating the environment of the indoor space.

For example, the sufficient conditions may be determined based on the accuracy of simulation results. The electronic device 100 may simulate the environment of the indoor space through a data visualization method according to computational flow dynamics based on the obtained spatial information. The sufficient conditions may be determined by whether an accuracy of 80 % or higher is secured with respect to the environment of the indoor space in consideration of the simulation results. The accuracy value is merely an example and does not limit the technical idea of the present disclosure, and may be set differently according to a user intention.

As another example, the sufficient conditions may be determined based on the number of observers that may measure the environment of the indoor space. The sufficient conditions may be determined based on the number of observers placed in the indoor space. The sufficient conditions may be determined based on the number of observers placed in the indoor space per unit area of the indoor space. Specifically, for example, the sufficient conditions may be determined by whether 10 or more observers are placed for every 100 square meters of indoor space. The area and the number of observers are merely examples and do not limit the technical idea of the present disclosure, and may be set differently according to a user intention.

As another example, the sufficient conditions may be set based on the state of a door, the state of a window, information about an obstacle, information about the placement state of an observer, etc. in the indoor space. Specifically, whether the sufficient conditions are satisfied may be determined based on whether the door of the indoor space is closed, whether the window is present, or whether more than a predetermined number of observers are placed. The degree of sufficient conditions may be merely set differently according to a user's intention, and does not limit the technical idea of the present disclosure.

In addition, the criteria of sufficient conditions may be set strictly or flexibly according to a user's intention, and examples of sufficient conditions do not limit the technical idea of the present disclosure.

In an embodiment, in operation S20, when the obtained spatial information is sufficient, the electronic device 100 may configure a virtual space corresponding to the indoor space based on the sufficient spatial information. The electronic device 100 may simulate an environmental change of the virtual space. The electronic device 100 may visualize the environmental change of the virtual space through simulation. A simulation method when the spatial information is sufficient may be a data visualization method based on computational flow dynamics, but does not limit the technical idea of the present disclosure.

In an embodiment, in operation S30, when the obtained spatial information is insufficient, the electronic device 100 may perform a color-based simulation on the indoor space. However, the color-based simulation is merely an example, and various methods that may explain a data difference (e.g., a temperature difference) of the indoor environment may be implemented. For example, a 3D-based simulation may be performed to explain the data difference.

The electronic device 100 may perform a heat map-based simulation. In the present disclosure, a heat map may be an image that outputs various pieces of information that may be represented in color as a visual graphic in the form of a thermal distribution on an indoor space image.

In an embodiment, the spatial information may be collected with respect to a room. For example, the electronic device 100 may set a target range within the indoor space. The electronic device 100 may determine whether the spatial information is sufficient, based on the spatial information about the set target range. For example, the target range may be one room included in the indoor space.

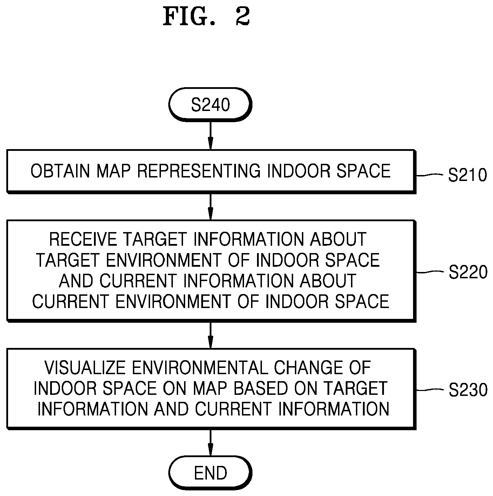

A detailed description of the simulation performed in operation S30 will be given below with reference to FIGS. 2 to 8.

The electronic device 100 according to an embodiment may communicate with the server 110. The electronic device 100 may transmit and receive data used in the above-described operations to and from the server 110. In this case, at least part of data processing performed in the above-described operations may be performed by the server 110.

FIG. 2 is a flowchart for explaining a method of visualizing an environment of an indoor space according to an embodiment of the present disclosure.

In operation S210, an electronic device may obtain spatial information about the indoor space. The indoor space may refer to a space within a house.

In an embodiment, the indoor space may refer to one room among spaces within the house. However, the scope of the indoor space does not limit the technical idea of the present disclosure, and the indoor space may be the entire house including a plurality of rooms.

According to an embodiment, the electronic device may obtain spatial information. The spatial information may include a map representing the indoor space. The spatial information may further include information about at least one of at least one external device and an obstacle placed in the indoor space.

In an embodiment, the electronic device may receive the spatial information from the at least one external device placed in the indoor space. For example, the at least one external device may generate location information for each, and the electronic device may receive location information of the at least one external device from the at least one external device.

In an embodiment, the electronic device may receive the spatial information from a server. The electronic device may receive a map of the indoor space from the server. The server may store maps of various indoor spaces, and data processing of the server may be performed by a processor of the electronic device.

According to an embodiment, the electronic device may receive spatial information from a user terminal. For example, a user may edit a map of the indoor space through the user terminal, and the electronic device may receive the edited map of indoor space from the user terminal. The user terminal may provide a predetermined application for editing the map. Data processing of the user terminal may be performed by the processor of the electronic device.

In operation S220, the electronic device may receive target information about a target environment of the indoor space and current information about a current environment of the indoor space.

In the present disclosure, each of the target environment and the current environment may include at least one of temperature, air quality, humidity, illuminance, or energy usage of the indoor space. Specifically, the target environment may include at least one of a target temperature, target air quality, target humidity, target illuminance, or target energy usage of the indoor space. The current environment may include at least one of a current temperature, current air quality, current humidity, current illumination, and current energy usage of the indoor space. However, this is merely an example, and the technical idea of the present disclosure is not limited thereto.

In an embodiment, the target information may be information about a target environment of the indoor space. The target environment may refer to a target for an actuator placed in the indoor space to change the environment of the indoor space. The target environment may be set by the actuator placed in the indoor space.

For example, the actuator may include an air conditioner that cools the indoor space so that a temperature of the indoor space reaches 21 degrees. The target environment may be 21 degrees, which is a target temperature of the indoor space.

In an embodiment, the electronic device may receive the target information from the actuator placed in the indoor space.

In an embodiment, the current information may be information about a current environment of the indoor space. The current environment may refer to a value measured by an observer placed in the indoor space about the environment of the indoor space. The current environment may be measured by the observer placed in the indoor space.

For example, the observer may include an electronic thermometer that measures a temperature of the indoor space.

In an embodiment, the electronic device may receive current information from the observer placed in the indoor space.

In an embodiment, the electronic device may receive the target information and the current information from an external device placed in the indoor space. The external device may be a device functioning as an actuator and an observer. For example, the external device may be an air conditioner that measures the temperature of the indoor space and cools the indoor space. The air conditioner may function as an actuator or as both the actuator and an observer depending on its provided functions.

In operation S230, the electronic device may visualize an environmental change of the indoor space on a map based on the target information and the current information.

In an embodiment, the electronic device may visualize the environment of the indoor space. The electronic device may overlap the environmental change of the indoor space on the map of the indoor space. For example, the electronic device may configure a virtual space corresponding to the indoor space. The electronic device may overlap the current environment on the virtual space based on the current information. The electronic device may generate a heat map in which the current environment within the virtual space is represented according to colors by overlapping the current environment on the virtual space based on the colors.

The electronic device may overlap the target environment on the generated heat map, based on the target information. The electronic device may generate a heat map in which the current environment and the target environment within the virtual space are represented according to colors by overlapping the target environment on the generated heat map.

In the present disclosure, the operation of generating the heat map representing the current environment and the target environment of the indoor space based on colors may be expressed in various terms such as simulation, visualization, and physical modeling, and the technical idea of the present disclosure is not limited thereto.

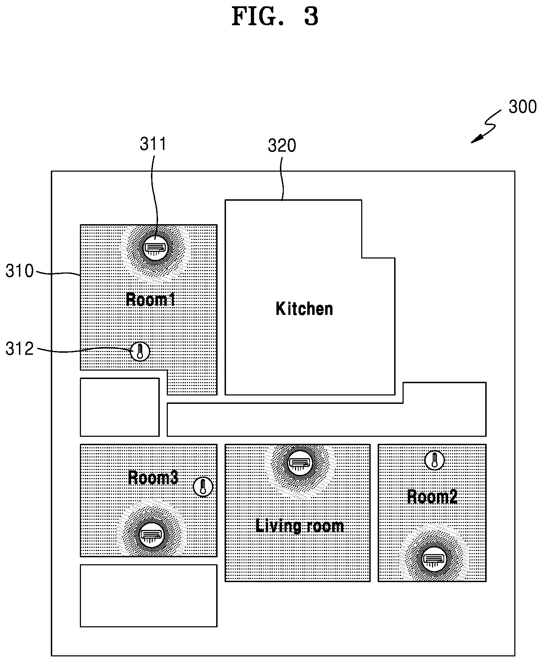

An example of the heat map in which the current environment and the target environment within the virtual space are represented according to colors will be described in detail with reference to FIG. 3.

FIG. 3 is a diagram illustrating an example of an image visualizing an environment on an indoor space according to an embodiment of the present disclosure.

Referring to FIG. 3, an electronic device may obtain a map 300 representing the indoor space. The obtained map 300 may include a structural diagram of the indoor space, but this is merely an example and does not limit the technical idea of the present disclosure. The electronic device may obtain the map 300 representing the indoor space as spatial information. The map 300 may be included in the spatial information.

In an embodiment, the electronic device may obtain the map 300 representing the indoor space from a server. The electronic device may receive the map 300 corresponding to a predetermined space from the server.

In an embodiment, the electronic device may obtain the edited map 300 according to a user input. The map 300 may be a map edited according to a user input based on a structural diagram corresponding to the predetermined space. For example, the map 300 may be a map in which editing is performed, such as a wall between a first room 310 and a kitchen 320 being torn down or the area of the first room 310 being reduced according to a user input.

In an embodiment, the map 300 may be a newly generated map according to the user input. According to the user input, not only the indoor space may be edited based on an existing structural diagram, but also a new indoor space may be generated.

The operation of configuring the map 300 may be performed by a processor and an input interface of the electronic device, or may be performed through a separate user terminal, and the electronic device may receive the map 300 from the user terminal.

In an embodiment, the indoor space represented on the map 300 may include the first room 310. For convenience of explanation, the first room 310 will be mainly described.

In an embodiment, a plurality of external devices may be placed within the first room 310. Two external devices 311 and 312 are illustrated as being placed within the first room 310, but the number of external devices that are placed does not limit the technical idea of the present disclosure, one external device or three or more external devices may be placed in the first room 310, and no external device may be placed in the first room 310. In FIG. 3, for convenience of explanation, the two external devices 311 and 312 are illustrated as being placed within the first room 310.

In an embodiment, the electronic device may visualize the current environment on the map 300 based on the current information. The electronic device may visualize the current environment through colors. For example, the electronic device may visualize a current environment of the first room 310 through blue-toned colors as a temperature of the first room 310 decreases. As another example, the electronic device may visualize the current environment of the first room 310 through red-toned colors as the temperature of the first room 310 increases.

In an embodiment, the current information may be measured by external devices placed in the indoor space. The current information may be measured by an observer among the external devices placed in the indoor space.

For example, the first external device 311 and the second external device 312 may be placed within the first room 310. The first external device 311 may be an observer that functions as an air conditioner capable of measuring a temperature. The current information may be measured by the first external device 311 placed within the first room 310. The second external device 312 may be an observer functioning as an electronic thermometer. The current information may be measured by the second external device 312 placed within the first room 310.

In an embodiment, the electronic device may determine the color of the first room 310 based on the current information measured by the second external device 312 within the first room 310. The electronic device may visualize the current environment on the first room 310, based on the determined color.

In an embodiment, the current information may be measured by a plurality of external devices placed in the indoor space. The current information may be calculated based on an average of values measured by a plurality of external devices.

For example, first current information may be measured by the first external device 311 placed within the first room 310. The second current information may be measured by the second external device 312 placed within the first room 310. The current information may be determined based on an average value of the first current information and the second current information.

In an embodiment, the electronic device may visualize the target environment on the map 300 based on the target information. The electronic device may visualize the target environment through colors. For example, the electronic device may visualize the target environment of the first room 310 through blue B-toned colors as the temperature of the first room 310 decreases. As another example, the electronic device may visualize the target environment of the first room 310 through red R-toned colors as the temperature of the first room 310 increases.

In an embodiment, the target information may be set by external devices placed in the indoor space. The target information may be set by an actuator among the external devices placed in the indoor space.

For example, the first external device 311 and the second external device 312 may be placed within the first room 310. The first external device 311 may be an actuator that functions as an air conditioner that cools space. The target information may be set by the first external device 311 placed within the first room 310.

In an embodiment, the electronic device may determine a target color of the first room 310 based on the target information set by the first external device 311 within the first room 310. The electronic device may visualize the target environment on a region around the first external device 311 based on the determined target color. The electronic device may visualize a gradation of the target environment on a concentric region around the first external device 311.

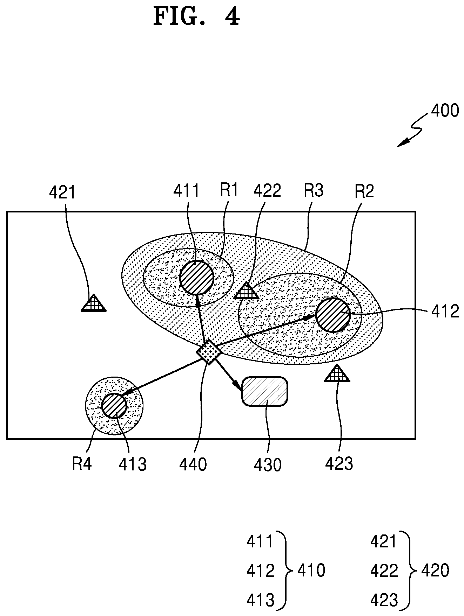

FIG. 4 is a diagram for explaining elements utilized in a simulation for visualizing an environment of an indoor space according to an embodiment of the present disclosure.

Referring to FIG. 4, an electronic device may visualize the environment of the indoor space on a map 400 representing the indoor space.

In an embodiment, the simulation for visualizing the environment of the indoor space may be performed based on an actuator 410, an observer 420, an obstacle 430, regions of interest (ROIs) R1, R2, R3, R4, and a singularity point 440.

In an embodiment, an external device placed in the indoor space may include the actuator 410 and the observer 420. The actuator 410 may be a device that changes an environment of space where placed. The observer 420 may be a device that measures an environment of space where placed.

In an embodiment, the electronic device may obtain spatial information including the map 400 of the indoor space and information about external devices placed in the indoor space, and the electronic device may perform a simulation based on the spatial information.

For example, as shown in FIG. 4, a situation in which a first actuator 411, a second actuator 412, and a third actuator 413 are placed within the indoor space may be visualized. A situation in which a first observer 421, a second observer 422, and a third observer 423 are placed within the indoor space may be visualized. An external device that performs functions of an actuator and an observer at the same time is also possible, but for convenience of explanation, the actuator and the observer will be described separately in FIG. 4.

In an embodiment, the obstacle 430 may include objects placed in the indoor space except for an external device. The obstacle 430 may include a general object that does not function as an actuator or an observer. For example, the obstacle 430 may include a general object such as a desk, a chair, a trash bin, a bag, shoes, etc. The obstacle 430 may include a general object that does not perform a function of measuring or predicting an environment of space where placed.

In an embodiment, the environment of the indoor space may be visualized by setting the ROIs R1, R2, R3, and R4 around the actuator 410. The ROIs R1, R2, R3, and R4 surrounding the actuator 410 in a circular shape may be set. However, this is merely an example, and ROIs surrounding the actuator 410 may be set differently according to the type and function of the actuator 410. For example, ROIs may have different sizes, and an elliptical ROI with a major axis in a predetermined direction may be set around an actuator 410 that influences the predetermined direction.

As shown in FIG. 4, the first ROI R1, the second ROI R2, the third ROI R3, and the fourth ROI R4 may have different sizes according to types and functions of the actuators 410, and the third ROI R3 with a major axis in a predetermined direction may be set.

In an embodiment, the electronic device may visualize the environment of the indoor space with respect to the actuator 410, the observer 420, and the ROIs R1 to R4. The electronic device may display the actuator 410 and the observer 420 on the map 400 representing the indoor space.

The electronic device may receive current information about a current environment of the indoor space measured by the observer 420. The electronic device may receive the current information from the observer 420. The electronic device may visualize the indoor space in a predetermined color based on the current information.

According to an embodiment, the electronic device may receive a plurality of pieces of current information from a plurality of observers 420. The electronic device may obtain average current information about the current environment of the indoor space based on the plurality of pieces of current information. For example, when the temperature of the indoor space is measured at 21, 23, and 25 degrees from the plurality of observers 420, the electronic device may obtain average current information of 23 degrees by averaging the plurality of pieces of current information. The electronic device may visualize the indoor space in a predetermined color based on the average current information.

The electronic device may receive target information about a target environment of the indoor space set by the actuator 410. The electronic device may receive the target information from the actuator 410. The electronic device may visualize an ROI surrounding the actuator 410 based on the target information.

For example, the electronic device may visualize the ROI in a predetermined color corresponding to the target environment based on the target information. The electronic device may gradate and visualize the ROI in a predetermined range of colors based on the target information.

In an embodiment, the electronic device may simulate the environment of the indoor space and detect the singularity point 440. The singularity point 440 may refer to a point at which inference of data is inconsistent with respect to the environment of the indoor space. The singularity point 440 may be detected based on at least one of target information obtained from the actuator 410 and current information obtained from the observer 420 within the indoor space.

For example, the plurality of pieces of current information may be current information obtained from each of the observers 420, for example, information about a temperature. The electronic device may obtain the average current information based on the plurality of pieces of current information, and may determine the temperature of the indoor space according to the average current information. The current information measured by the third observer 423 from among the plurality of pieces of current information may be greatly different from the average current information. However, a difference between the average current information and the current information for determining the singularity point 440 may be set differently according to a user's intention.

For example, the average current information may be 25 degrees, whereas the current information measured by the third observer 423 may be 20 degrees. Because the average current information and the current information have a difference of 10 % or more, the electronic device may determine that the current information measured by the third observer 423 does not properly measure the environment of the actual indoor space, and may determine that the singularity point 440 has occurred.

As another example, the target information may be 23 degrees, and the current information may be 28 degrees. The indoor space is cooled by the actuator based on the target information, but the current information may be maintained at 28 degrees over time. In this case, the electronic device may determine that inference of data is inconsistent with respect to the environment of the indoor space, and may determine that the singularity point 440 has occurred.

As another example, the current information measured with respect to the indoor space may not be realistically obtained at -50 degrees. The criterion of whether the current information is not realistic may vary according to a user's intention, and the electronic device may determine whether the current information is not realistic according to a preset criterion. When it is determined that the current information is not realistic, the electronic device may determine that the singularity point 440 has occurred at a location determined as -50 degrees.

In an embodiment, the electronic device may determine that inconsistency of data occurs in a simulation of the environment of the indoor space based on the occurrence of the singularity point 440. The electronic device may generate a solution for solving the inconsistency of data based on the occurrence of the singularity point 440. The solution may refer to a solution provided as feedback to reduce a difference between data on the environment of the indoor space and the actual environment of the indoor space occurs. The solution may refer to a solution provided to reduce a gap between the target environment and the current environment.

For example, when current information measured by an observer remains constant despite an operation of an actuator, the solution may include a solution to replace the observer.

In an embodiment, the electronic device may perform a simulation of the indoor space regardless of whether the spatial information about the indoor space is sufficient. Therefore, the accuracy of the simulation may vary depending on the amount of spatial information. The electronic device may determine the occurrence of the singularity point 440 in preparation for a case where the accuracy of the simulation decreases. The electronic device may detect a situation in which data on the indoor environment do not match based on the singularity point 440. The electronic device may generate and provide a solution for each situation based on the singularity point 440.

In an embodiment, even when the spatial information is insufficient, the electronic device may reduce an error in the simulation by providing a solution that utilizes the singularity point 440. Accordingly, even though the observer 420 placed in the indoor space is insufficient, the electronic device according to the present disclosure may visualize the environment of the indoor space.

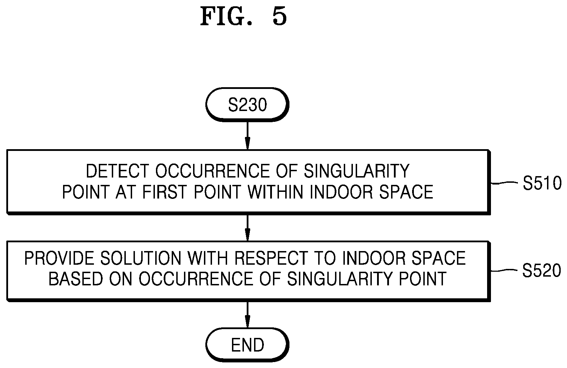

FIG. 5 is a flowchart illustrating a method of providing a solution as a result of a simulation visualizing an environment of an indoor space according to an embodiment of the present disclosure.

Referring to FIG. 5, operation S510 may be performed after operation S230 of FIG. 2.

In operation S510, an electronic device may detect the occurrence of a singularity point at a first point within the indoor space.

In an embodiment, the singularity point may refer to a point or situation in which inference of data is inconsistent with respect to the environment of the indoor space. The occurrence of the singularity point may mean the occurrence of a gap between a target environment and a current environment with respect to the first point.

In an embodiment, the singularity point may be detected based on at least one of target information obtained from an actuator within the indoor space and current information obtained from an observer.

For example, when a current temperature according to the current information remains constant even though the indoor space is sufficiently cooled by the actuator, the electronic device may detect that the singularity point has occurred. However, the criteria as to how long the current temperature needs to remain constant to determine that the singularity point has occurred may vary according to a user's intention, and may be preset. This does not limit the technical idea of the present disclosure.

In another example, although a temperature of the indoor space is measured by a plurality of observers and a plurality of pieces of current information is obtained, when current information measured by one observer is significantly different from the plurality of pieces of current information, the electronic device may detect that the singularity point has occurred. However, the criteria as to how much different the current information is compared to the plurality of pieces of current information to determine that the singularity point has occurred may vary according to a user's intention, and may be preset. This does not limit the technical idea of the present disclosure.

In operation S520, the electronic device may generate a solution with respect to the indoor space based on the occurrence of the singularity point. The electronic device may generate a solution corresponding to the singularity point. The electronic device may provide a solution corresponding to the singularity point.

In an embodiment, the solution may be a solution corresponding to a predetermined situation indicated by the detected singularity point. The electronic device may obtain a solution by applying the detected singularity point to an Al model. The Al model may be a model trained based on a plurality of training singularity points and corresponding training solutions. The Al model may be a model trained to derive a solution in response to the singularity point.

In an embodiment, the solution may include information associated with detection of a malfunction of at least one external device. The solution may include information detecting the malfunction of at least one external device based on a change in the current environment. For example, when current information measured by an observer remains constant despite an operation of an actuator, the solution may include a solution to replace the observer.

In an embodiment, the solution may include information associated with a placement of an additional external device in the indoor space. The solution may include information about a proposal to place the additional external device in the indoor space based on the difference between the target environment and the current environment. For example, when current information measured by a predetermined observer changes slowly because the indoor space is larger than the actuator in operation, the electronic device may determine that a singularity point has occurred. The electronic device may generate a solution to add an observer based on the generated singularity point.

In an embodiment, the solution may include information associated with a location change of at least one external device placed in the indoor space. The singularity point may be detected based on locations of obstacle, actuator, and observer placed in the indoor space, the current information, and the target information. The electronic device may generate a solution for a proposal to change the location of at least one external device based on the difference between the target environment and the current environment, based on the detected singularity point. For example, as the actuator and the obstacle are disposed side by side in the indoor space, a speed at which the current information measured by the observer changes may be slow despite the operation of the actuator. In this case, the electronic device may generate a solution to change a placement of the actuator or the obstacle.

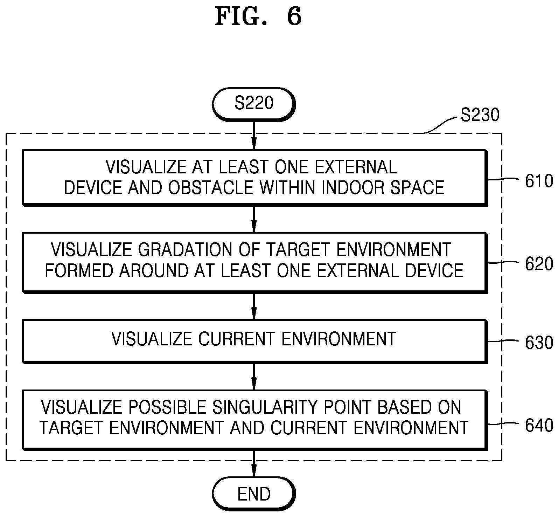

FIG. 6 is a flowchart for specifically explaining a method of visualizing an environment of an indoor space according to an embodiment of the present disclosure.

Referring to FIG. 6, operation S230 of FIG. 2 may include operations S610 to S640. Descriptions that are redundant with those described with reference to FIG. 2 are simplified or omitted.

In operation S610, an electronic device may visualize at least one external device and an obstacle within the indoor space.

In an embodiment, the electronic device may visualize a map representing the indoor space. For example, the electronic device may visualize a structural diagram of the indoor space.

In an embodiment, the electronic device may visualize the at least one external device and the obstacle placed within the indoor space on a map of the indoor space. The at least one external device and the obstacle may be represented as a simplified image, but may be represented in various ways, such as simple figures and actual shapes.

In operation S620, the electronic device may visualize a gradation of a target environment formed around the at least one external device.

In an embodiment, the at least one external device may include an actuator. The actuator may be a device that may set a target environment to change the environment within the indoor space and influence the indoor space so that the environment within the indoor space reaches the target environment. The electronic device may obtain target information about the target environment from the actuator.

The electronic device may generate a gradation formed around the at least one external device based on the target information. The electronic device may visualize the gradation around the at least one external device. The electronic device may visualize the gradation around the actuator. The gradation may refer to a method of representing a surrounding environment of the at least one external device, and may be a representation of an environment that changes as a change in color farther away from the at least one external device.

In an embodiment, the gradation may be visualized in a circular shape around the actuator, but may be visualized in various forms according to the type and function of the actuator. For example, the gradation may be visualized in one direction from the actuator, or the gradation may be visualized in a square around the actuator.

In an embodiment, the gradation may represent an environment in which a change is expected around the at least one external device. For example, the electronic device may visualize the environment of the indoor space based on a color. Using the temperature as an example for the convenience of explanation, in general, low temperatures may be represented in blue-toned colors in the environment of the indoor space, and high temperatures may be represented in red-toned colors in the environment of the indoor space.

Using a heater as an example, the electronic device may visualize a circular gradation around the heater. The visualized gradation may include red-toned colors closer to the heater, and may include blue-toned colors farther away from the heater.

In operation S630, the electronic device may visualize the current environment.

In an embodiment, the at least one external device may include an observer. The observer may measure the environment within the indoor space and obtain current information about the current environment. The electronic device may receive the current information from the at least one external device.

The electronic device may visualize the current environment of the indoor space in which the at least one external device is placed based on the current information. For example, the electronic device may visualize the indoor space in color based on the current information.

Using the temperature as an example of the environment for convenience of explanation, the indoor space at a low temperature may be visualized in blue-toned colors, and the indoor space at a high temperature may be visualized in red-toned colors.

In operation S640, the electronic device may visualize a possible singularity point based on the target environment and the current environment.

In an embodiment, the electronic device may detect the occurrence of the singularity point based on the target environment and the current environment. The electronic device may obtain the target information and the current information, and may detect the occurrence of the singularity point in consideration of the target information and the current information. The electronic device may determine whether the singularity point occurs by inputting the target information and the current information to an Al model.

The Al model may be a model that is trained to determine reliability of a measured value for an environment and finally determine whether a singularity point has occurred by inputting data about the environment. The Al model may be a model that determines whether input data is abnormal based on the input data about the environment.

For example, when the electronic device obtains the current information that remains constant even though the actuator influences the environment of the indoor space, the electronic device may use the Al model to determine whether the current information is abnormal and determine that the singularity point has occurred.

As another example, the electronic device may obtain a plurality of pieces of current information about the environment of the indoor space measured by a plurality of observers. One of the plurality of pieces of current information may be significantly different from the other current information.

Specifically, using the temperature as an example, the others of the plurality of pieces of current information may be measured in the range of 25 degrees to 28 degrees, but one of the plurality of pieces of current information may be measured at 15 degrees. In this case, the electronic device may use the Al model to determine whether the current information is abnormal and determine that the singularity point has occurred.

However, the criteria as to how much different one of the plurality of pieces of current information is to be determined to be abnormal may vary depending on a user's intention, and may differ depending on a method of training the Al model.

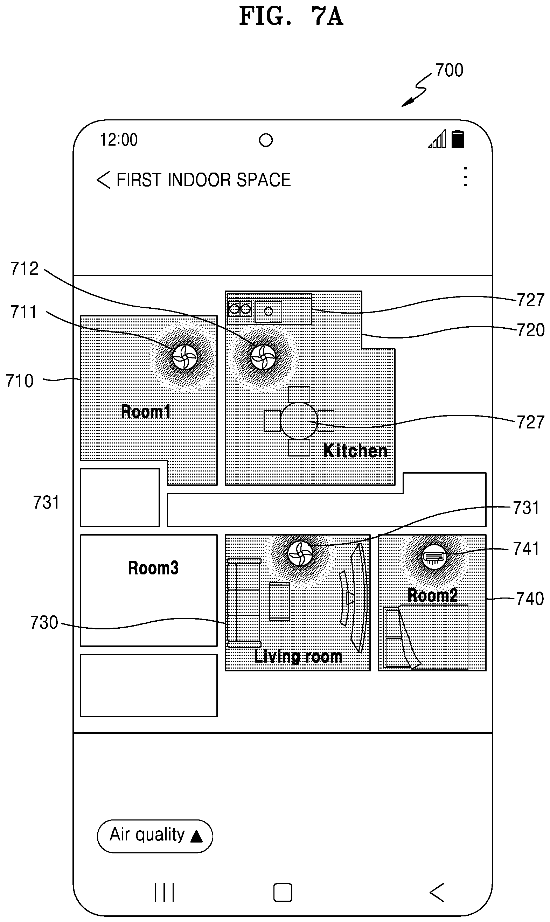

A method of visualizing the environment of the indoor space of FIG. 6 will be described in detail below with reference to FIGS. 7A to 7B.

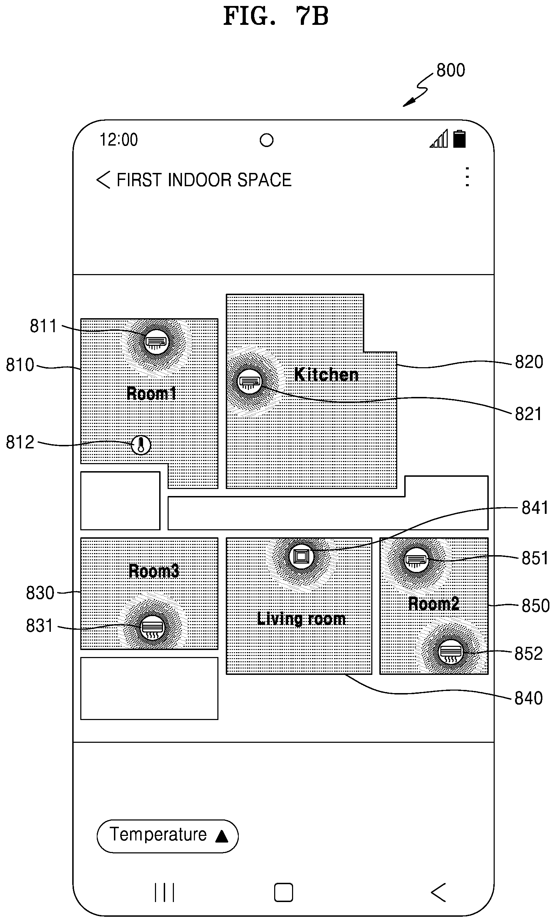

FIGS. 7A and 7B are diagrams for explaining user interfaces for providing, to a user, images in which an environment of an indoor space is visualized according to an embodiment of the present disclosure.

For reference, FIG. 7A illustrates an image visualizing air quality as an example of the environment of the indoor space. FIG. 7B illustrates an image visualizing a temperature as an example of the environment of the indoor space.

For convenience of explanation, descriptions that are redundant with those described with reference to FIGS. 3 to 6 are simplified or omitted.

Referring to FIG. 7A, an electronic device may obtain a map 700 of a first indoor space. FIG. 7A illustrates a screen on which the map 700 of the first indoor space is displayed. The map 700 of the first indoor space may be displayed through a display of the electronic device, but this is merely an example and may also be displayed through a separate device.

According to an embodiment, the electronic device may obtain the map 700 representing the first indoor space from a server. According to an embodiment, the electronic device may obtain the edited map 700 according to a user input. The electronic device may receive the edited map 700 from a user terminal. According to an embodiment, the electronic device may obtain the map 700 newly generated by a user input. The electronic device may receive the generated map 700 from the user terminal.

However, this is merely an example, and the method of obtaining the map 700 does not limit the technical idea of the present disclosure. For example, an operation performed by the user terminal or server may be performed by a processor of the electronic device, and the electronic device may directly generate the map 700 representing the first indoor space.

In an embodiment, the first indoor space may include first to fourth rooms 710, 720, 730, and 740. For convenience of explanation, four rooms in a house structure corresponding to the first indoor space will be described.

In an embodiment, at least one external device may be placed within each room. For reference, FIG. 7A is a diagram for explaining the screen visualizing air quality of the indoor space, and an indoor space simulation according to an embodiment is visualized with respect to an actuator which is a component necessary for visualizing air quality among the at least one external device.

The at least one external device may be placed within the first room 710. The at least one external device may include an actuator or an observer. A first actuator 711 may be placed within the first room 710. For example, the first actuator 711 may be a ventilation device that improves air quality in the indoor space.

In an embodiment, the electronic device may visualize the first actuator 711 on the map 700. The electronic device may actually visualize the first actuator 711 at a location on the map 700 corresponding to a location where the first actuator 711 is placed in the indoor space.

In an embodiment, the electronic device may visualize at least one obstacle on the map 700. The electronic device may actually visualize the at least one obstacle at a location on the map 700 corresponding to a location where the at least one obstacle is placed in the indoor space. For example, as shown in FIG. 7A, the electronic device may visualize a first obstacle 726 and a second obstacle 727 within the second room 720. The second room 720 may be a kitchen.

However, the locations and number of actuators and obstacles may vary according to each indoor space, which does not limit the technical idea of the present disclosure. The types of actuators and obstacles may also vary.

The electronic device may provide an image visualizing the map 700, at least one actuator, and at least one obstacle disposed on the map 700. The electronic device may display an image visualizing the map 700, at least one actuator, and at least one obstacle disposed on the map 700.

In an embodiment, current information may be measured by an observer placed in the indoor space. The current information may be measured by an observer among external devices disposed in the indoor space. The electronic device may receive the current information from the observer. Although the observer is not visualized in FIG. 7A, the electronic device may receive the current information from the observer. For example, the electronic device may obtain current information about measuring air quality in the first room 710 from a predetermined observer placed within the first room 710.

In an embodiment, the electronic device may visualize a current environment on the map 700 based on the current information. For example, as the air quality of a predetermined space is better, the electronic device may visualize a current environment of the predetermined space through blue (B)-toned colors. As another example, as the air quality of the predetermined space is poorer, the electronic device may visualize the current environment of the predetermined space through red (R)-toned colors.

For example, the electronic device may visualize the air quality of the first room 710 in green based on current information measuring the air quality within the first room 710. A user viewing a simulation in which the electronic device according to an embodiment visualizes the indoor space may confirm that the current air quality of the first room 710 is 'good'.

In addition, the electronic device may visualize the air quality of the fourth room 740 in red based on current information measuring the air quality within the fourth room 740. The user viewing a simulation in which the electronic device according to an embodiment visualizes the indoor space may confirm that the current air quality of the fourth room 740 is 'bad'.

In an embodiment, the electronic device may visualize a target environment on the map 700 based on target information. In an embodiment, the target information may be set by external devices placed in the indoor space. The target information may be set by an actuator among the external devices placed in the indoor space.

The electronic device may visualize the target environment on the map 700 based on the target information. The electronic device may visualize a gradation of a target environment formed around at least one actuator. As the air quality of a predetermined space is better, the electronic device may visualize a current environment of the predetermined space through blue (B)-toned colors. As the air quality of the predetermined space is poorer, the electronic device may visualize the current environment of the predetermined space through red (R)-toned colors.

For example, the current air quality of the fourth room 740 within the map 700 may be 'bad'. A fourth actuator 741 may be placed within the fourth room 740. For example, the fourth actuator 741 may be an air purifier that improves air quality of the indoor space. The air purifier may be a device that purifies air so that the current air quality of a surrounding space reaches a predetermined target air quality.

The electronic device may visualize a gradation of the target air quality formed around the fourth actuator 741. The gradation may refer to a method of representing a surrounding environment of the fourth actuator 741, and may be a representation of an environment that changes as a change in color farther away from the fourth actuator 741.

For example, the electronic device may visualize a semicircle close to the fourth actuator 741 as a color corresponding to the target air quality, such as blue B, and may visualize red R to become darker on a semicircle with respect to the fourth actuator 741 farther away from the fourth actuator 741.

The first room 710, the second room 720, and the third room 730 may also be visualized in the same manner, which is the same as a method of visualizing the fourth room 740, and thus, descriptions thereof will be omitted. However, because the current air quality of the first room 710, the second room 720, and the third room 730 is evaluated as 'good', a color corresponding to the current environment and a color corresponding to the target environment may not be significantly different.

Descriptions that are redundant with those described with reference to FIG. 7A are simplified or omitted.

Referring to FIG. 7B, the electronic device may obtain a map 800 of a first indoor space. FIG. 7B illustrates a screen on which the map 800 of the first indoor space is displayed.

In an embodiment, the first indoor space may include first to fifth rooms 810, 820, 830, 840, and 850. For convenience of explanation, five rooms in a house structure corresponding to the first indoor space will be described.

In an embodiment, at least one external device may be placed within each room. For reference, FIG. 7B is a diagram for explaining the screen visualizing a temperature of the indoor space, and an indoor space simulation according to an embodiment is visualized with respect to an actuator and an observer which are components necessary for temperature visualization among the at least one external device.

The at least one external device may be placed within the first room 810. The at least one external device may include an actuator or an observer. A first actuator 811 and a first observer 812 may be placed within the first room 810. For example, the first actuator 811 may be an air conditioner that cools the indoor space. The first observer 812 may be an electronic thermometer that measures the temperature of the indoor space.

In an embodiment, the electronic device may visualize the first actuator 811 on the map 800. The electronic device may visualize the first actuator 811 at a location where the first actuator 811 is placed. The electronic device may visualize the first observer 812 on the map 800. The electronic device may visualize the first observer 812 at the location where the first actuator 812 is placed.

In an embodiment, the electronic device may provide an image visualizing the map 800, at least one actuator, at least one observer, and at least one obstacle disposed on the map 800. The electronic device may display an image visualizing the map 800, at least one actuator, and at least one obstacle disposed on the map 800.

In an embodiment, current information may be measured by an observer placed in the indoor space. The current information may be measured by an observer among external devices placed in the indoor space. The electronic device may receive the current information from the observer. For example, the electronic device may obtain current information about measuring the temperature within the first room 810 from the first observer 812 placed within the first room 810.

In an embodiment, the electronic device may visualize a current environment on the map 800 based on the current information. For example, as the temperature of a predetermined space decreases, the electronic device may visualize a current environment of the predetermined space through blue (B)-toned colors. As another example, as the temperature of the predetermined space increases, the electronic device may visualize the current environment of the predetermined space through red (R)-toned colors.

As shown in FIG. 7B, the electronic device may visualize the temperature of the first room 810 in green based on current information measuring the temperature within the first room 810. A user viewing a simulation in which the electronic device according to an embodiment visualizes the indoor space may confirm that the temperature of the first room 810 is 15 degrees to 20 degrees.

In addition, the electronic device may visualize the temperature of the third room 830 in red based on current information measuring the temperature within the third room 830. The user viewing a simulation in which the electronic device according to an embodiment visualizes the indoor space may confirm that the temperature of the third room 830 is 25 degrees to 30 degrees.

In an embodiment, the electronic device may visualize a target environment on the map 800 based on target information. In an embodiment, the target information may be set by external devices placed in the indoor space. The target information may be set by an actuator among the external devices placed in the indoor space.

The electronic device may visualize the target environment on the map 800 based on the target information. The electronic device may visualize a gradation of a target environment formed around at least one actuator. As the temperature of the predetermined space decreases, the electronic device may visualize the current environment of the predetermined space through blue (B)-toned colors. As the temperature of the predetermined space increases, the electronic device may visualize the current environment of the predetermined space through red (R)-toned colors.

For example, the temperature of the second room 820 within the map 800 may be high. A second actuator 821 may be placed within the second room 820. For example, the second actuator 821 may be an air conditioner that cools the indoor space. The air conditioner may be a device that cools air so that the current temperature of a surrounding space reaches a predetermined target temperature.

The electronic device may visualize a gradation of a target temperature formed around the second actuator 821. The gradation may refer to a method of representing a surrounding environment of the second actuator 821, and may be a representation of an environment that changes as a change in color farther away from the second actuator 821.

For example, the electronic device may visualize a semicircle close to the second actuator 821 as a color corresponding to the target temperature, for example, the blue B. The electronic device may visualize the red R to become darker on a semicircle with respect to the second actuator 821 farther away from the second actuator 821.

The first room 810, the third room 830, the fourth room 840, and the fifth room 850 may also be visualized in the same manner, which is the same as a method of visualizing the second room 820, and thus, descriptions thereof will be omitted.

However, in an embodiment, a plurality of actuators may be placed in one room. For example, a third actuator 851 and a fourth actuator 852 may be placed within the fifth room 850. The electronic device may visualize a first gradation of a target temperature formed around the third actuator 851, and may visualize a second gradation of a target temperature formed around the fourth actuator 852.

FIG. 8 is a diagram for explaining a configuration of an electronic device for visualizing an environment of an indoor space according to an embodiment of the present disclosure.

An electronic device 1000 according to an embodiment of the present disclosure may include various types of assistant robots or mobile devices driven for user convenience, augmented reality (AR) devices, virtual reality (VR) devices, and devices that detect surrounding environments and provide predetermined services at a specific location or space.

Referring to FIG. 8, the electronic device 1000 according to an embodiment of the present disclosure may include a processor 1030, a communication module 1040, a user interface 1050, and memory 1060.

In an embodiment, the processor 1030 may execute instructions or programmed software modules stored in the memory 1060 to control operations or functions so that the electronic device 1000 may perform tasks. The processor 1030 may include hardware components that perform arithmetic, logic, and input/output operations and signal processing. The processor 1030 may execute one or more instructions stored in the memory 1060 to control the overall operations of the electronic device 1000 to manage an integrated map. The processor 1030 may execute programs stored in the memory 1060 to control the communication module 1040, and the user interface 1050.

The processor 1030 according to an embodiment of the disclosure may include, for example, at least one of a central processing unit (CPU), a microprocessor, a graphics processing unit (GPU), an application specific integrated circuit (ASIC), a digital signal processor (DSP), a digital signal processing device (DSPD), a programmable logic device (PLD), a field programmable gate array (FPGA), an application processor (AP), a neural processing unit (NPU), or a dedicated Al processor designed with a hardware structure specialized for processing an Al model, but the present disclosure is not limited thereto. Each processor constituting the processor 1030 may be a dedicated processor for performing a predetermined function.

In an embodiment, the Al processor may use an Al model to perform calculation and control to process a task set to be performed by the electronic device 1000. The Al processor may be manufactured in the form of a dedicated hardware chip for Al, or may be manufactured as part of a general-purpose processor (e.g., a CPU or an AP) or a GPU and mounted on the electronic device 1000.

In an embodiment, the communication module 1040 may include one or more components that enable the electronic device 1000 to communicate with an external device. For example, the communication module 1040 may include a short-range wireless communication module 1041, a long-range wireless communication module 1042, etc., but is not limited thereto.

The short-range wireless communication module 1041 may include a Bluetooth communication module, a Bluetooth Low Energy (BLE) communication module, an NFC communication module, a wireless local area network (WLAN) (Wi-Fi) communication module, a ZigBee communication module, an Ant+ communication module, a Wi-Fi Direction (WFD) communication module, an Ultra-Wideband (UWB) communication module, an Infrared Data Association (IrDA) communication module, a micro wave (uWave) communication module, etc., but is not limited thereto

In an embodiment, the user interface 1050 may include an input interface 1051 and an output interface 1052. In the user interface 150, the input interface 1051 and the output interface 1052 may be provided in a separated form or may be provided in an integrated form, such as a touch screen. The user interface 150 may receive input information from a user and provide output information to the user.

The input interface 1051 may refer to a means for the user to input data for controlling the electronic device 1000. For example, the input interface 1051 may include a key pad, a touch pad (a contact capacitance type touch pad, a pressure resistance film type touch pad, an infrared detection type touch pad, a surface ultrasonic conduction type touch pad, an integral tension measurement type touch pad, a piezo effect type touch pad, etc.), etc. In addition, the input interface 1051 may include a jog wheel, a jog switch, etc., but is not limited thereto

The output interface 1052 may output an audio signal, a video signal, or a vibration signal, and may include a display, a sound output interface, and a vibration motor.

The display may display information processed by the electronic device 1000. For example, the display may display an interface that receives a user's manipulation. When the display and a touch pad are configured as a touch screen having a layer structure, the display may be used as an input device as well as an output device. The display may include at least one of a liquid crystal display, a thin-film transistor-liquid crystal display, an organic light-emitting diode, a flexible display, or a 3D display. The electronic device 1000 may include two or more displays according to the implementation mode of the electronic device 1000.

The sound output interface may output audio data stored in the memory 1060. The sound output interface may output sound signals related to the functions performed by the electronic device 1000. The sound output interface may include a speaker, a buzzer, etc.

The vibration motor may output a vibration signal. For example, the vibration motor may output a vibration signal corresponding to an output of audio data or video data. The vibration motor may output a vibration signal when a touch is input to the touch screen.

In an embodiment, the memory 1060 may store a program for processing and control by the processor 1030 and may store data (e.g., integrated map, spatial information, user request, etc.) input to or output from the electronic device 1000. The memory 1060 may store instructions, a data structure, and program code, which are readable by the processor 1030. In the disclosed embodiments, operations performed by the processor 1030 may be implemented by executing instructions or codes of the program stored in the memory 1060.

For example, the memory 1060 may include flash memory-type memory, hard disk-type memory, multimedia card micro-type memory, or card-type memory (e.g., secure digital (SD) or extreme digital (XD) memory), a non-volatile memory including at least one of read-only memory (ROM), electrically erasable programmable read-only memory (EEPROM), programmable read-only memory (PROM), magnetic memory, magnetic disc, or optical disc, and a volatile memory, such as random access memory (RAM) or static random access memory (SRAM).

In an embodiment, the memory 1060 may store one or more instructions and/or programs that control the electronic device 1000 to perform tasks.

The machine-readable storage medium may be provided in the shape of a non-transitory storage medium. Here, the 'non-transitory storage medium' only denotes a tangible device and does not include a signal (e.g., electromagnetic waves). This term does not distinguish a case where data is stored in the storage medium semi-permanently and a case where the data is stored in the storage medium temporarily. For example, the 'non-transitory storage medium' may include a buffer where data is temporarily store.

According to an embodiment, a method according to various embodiments of the disclosure in the specification may be provided by being included in a computer program product. The computer program product, which is a commodity, may be traded between sellers and buyers. The computer program product may be distributed in the shape of machine-readable storage medium (e.g., compact disc read only memory (CD-ROM)), or distributed (e.g., downloaded or uploaded) through an application store or directly and online between two user devices (e.g., smartphones). In the case of online distribution, at least a part of the computer program product (e.g., a downloadable app) may be at least temporarily generated or temporarily stored in a machine-readable storage medium, such as a server of a manufacturer, a server of an application store, or memory of a relay server.

A method according to an embodiment may include obtaining a map representing an indoor space. The method may include receiving target information about a target environment of the indoor space and current information about a current environment of the indoor space. The method may include visualizing an environmental change of the indoor space on the map based on the target information and the current information.

In an embodiment, the method may further include detecting an occurrence of a singularity point at a first point within the indoor space based on the visualizing. The method may further include providing a solution with respect to the indoor space based on the occurrence of the singularity point.

In an embodiment, the occurrence of the singularity point may include an occurrence of a gap between the target environment and the current environment with respect to the first point.

In an embodiment, the solution may include information associated with a location change of at least one external device placed in the indoor space.

In an embodiment, the solution may include information associated with a placement of an additional external device in the indoor space.

In an embodiment, the solution may include information associated with the detection of a malfunction of at least one external device placed in the indoor space.

In an embodiment, the obtaining of the map may include receiving the map from a server or obtaining the map edited by a user input from a user terminal.

In an embodiment, each of the target environment and the current environment may include at least one of temperature, air quality, humidity, illuminance, or energy usage of the indoor space.

In an embodiment, the target information and the current information may be received from at least one external device placed in the indoor space. The at least one external device may include a first external device configured to influence an environment of the indoor space to reach the target environment and a second external device configured to obtain the current information. The target information may be received from the first external device. The current information may be received from the second external device.

In an embodiment, the target information and the current information may be received from at least one external device placed in the indoor space. The at least one external device may include a third external device configured to influence an environment of the indoor space to reach the target environment and obtain the current information. The target information and the current information may be received from the third external device.

In an embodiment, the visualizing of the environmental change of the indoor space may include visualizing at least one external device and an obstacle, within the indoor space. The visualizing of the environmental change of the indoor space may include visualizing a gradation of the target environment formed around the at least one external device. The visualizing of the environmental change of the indoor space may include visualizing the current environment. The visualizing of the environmental change of the indoor space may include visualizing a possible singularity point based on the target environment and the current environment.

An electronic device according to an embodiment may include memory and at least one processor. The memory may store one or more instructions. The at least one processor may execute a program or one or more instructions stored in the memory to cause the electronic device to obtain a map representing an indoor space. The electronic device may receive target information about a target environment of the indoor space and current information about a current environment of the indoor space. The electronic device may visualize an environmental change of the indoor space on the map based on the target information and the current information.

In an embodiment, the electronic device may detect an occurrence of a singularity point at a first point within the indoor space based on the visualizing. The electronic device may provide a solution with respect to the indoor space based on the occurrence of the singularity point.

In an embodiment, the occurrence of the singularity point may include an occurrence of a gap between the target environment and the current environment with respect to the first point.

In an embodiment, the solution may include information associated with a location change of at least one external device.

In an embodiment, each of the target environment and the current environment may include at least one of temperature, air quality, humidity, illuminance, or energy usage of the indoor space.

In an embodiment, the target information and the current information may be received from at least one external device placed in the indoor space. The at least one external device may include a first external device configured to influence an environment of the indoor space to reach the target environment and a second external device configured to obtain the current information. The target information may be received from the first external device. The current information may be received from the second external device.

In an embodiment, the target information and the current information may be received from at least one external device placed in the indoor space. The at least one external device may include a third external device configured to influence an environment of the indoor space to reach the target environment and obtain the current information. The target information and the current information may be received from the third external device.

In an embodiment, the electronic device may visualize at least one external device and an obstacle, within the indoor space, when visualizing the environmental change of the indoor space. The electronic device may visualize a gradation of the target environment formed around the at least one external device. The electronic device may visualize the current environment. The electronic device may visualize a possible singularity point based on the target environment and the current environment.

A computer-readable recording medium may have recorded thereon a program for performing a method according to an embodiment, on a computer, may be provided.

The aforementioned descriptions of the present disclosure are merely examples, and one of ordinary skill in the art may easily understand that various modifications may be made therein without departing from the spirit or features of the present disclosure. Therefore, it is to be understood that the embodiments described above should be considered in a descriptive sense only and not for purposes of limitation. For example, configuring components that are singular forms may be executed in a distributed fashion, and also, configuring components that are distributed may be combined and then executed.

The scope of the present disclosure is defined not by the above detailed description but by the following claims, and all modifications derived from the meaning and scope of the claims and equivalent concepts thereof should be construed as being included in the scope of the present disclosure.

## Claims

1. A method comprising:
obtaining a map representing an indoor space;
receiving target information about a target environment of the indoor space and current information about a current environment of the indoor space; and
visualizing an environmental change of the indoor space on the map based on the target information and the current information.

2. The method of claim 1, further comprising:
detecting an occurrence of a singularity point at a first point within the indoor space based on the visualizing; and
providing a solution with respect to the indoor space based on the occurrence of the singularity point.

3. The method of claim 2, wherein
the occurrence of the singularity point includes an occurrence of a gap between the target environment and the current environment with respect to the first point.

4. The method of any one of claims 2 and 3, wherein
the solution includes information associated with a location change of at least one external device placed in the indoor space.

5. The method of any one of claims 2 and 3, wherein
the solution includes information associated with a placement of an additional external device in the indoor space.

6. The method of any one of claims 2 and 3, wherein
the solution includes information associated with a detection of a malfunction of at least one external device placed in the indoor space.

7. The method of any one of claims 1 to 6, wherein
the target environment and the current environment respectively include at least one of temperature, air quality, humidity, illuminance, or energy usage of the indoor space.

8. The method of any one of claims 1 to 7, wherein
the target information and the current information are received from at least one external device placed in the indoor space,
the at least one external device includes a first external device configured to influence an environment of the indoor space to reach the target environment and a second external device configured to obtain the current information,
the target information is received from the first external device, and the current information is received from the second external device.

9. The method of any one of claims 1 to 7, wherein
the target information and the current information are received from at least one external device placed in the indoor space,
the at least one external device includes a third external device configured to influence an environment of the indoor space to reach the target environment and obtain the current information, and
the target information and the current information are received from the third external device.

10. The method of any one of claims 1 to 9, wherein
the visualizing of the environmental change of the indoor space includes visualizing at least one external device and an obstacle, within the indoor space;
visualizing a gradation of the target environment formed around the at least one external device;
visualizing the current environment; and
visualizing a possible singularity point based on the target environment and the current environment.

11. An electronic device comprising:
memory storing one or more instructions; and
at least one processor,
wherein the at least one processor is configured to execute a program or the one or more instructions stored in the memory to cause the electronic device to
obtain a map representing an indoor space,
receive target information about a target environment of the indoor space and current information about a current environment of the indoor space, and
visualize an environmental change of the indoor space on the map based on the target information and the current information.

12. The electronic device of claim 11, wherein
the target environment and the current environment respectively include at least one of temperature, air quality, humidity, illuminance, or energy usage of the indoor space.

13. The electronic device of any one of claims 11 and 12, wherein
the target information and the current information are received from at least one external device placed in the indoor space,
the at least one external device includes a first external device configured to influence an environment of the indoor space to reach the target environment and a second external device configured to obtain the current information,
the target information is received from the first external device, and the current information is received from the second external device.

14. The electronic device of any one of claims 11 to 13, wherein
wherein the at least one processor is configured to execute a program or the one or more instructions stored in the memory to cause the electronic device to, when visualizing the environmental change of the indoor space, visualize at least one external device and an obstacle, within the indoor space,
visualize a gradation of the target environment formed around the at least one external device,
visualize the current environment; and
visualize a possible singularity point based on the target environment and the current environment.

15. A computer-readable recording medium having a program recorded thereon to cause a computer to perform the method of any one of claims 1 to 10.
